(19) Europäisches Patentamt
European Patent Office
Office européen des brevets

(11) **EP 1 959 508 A1**

(12) **EUROPEAN PATENT APPLICATION**
published in accordance with Art. 158(3) EPC

(43) Date of publication:
   **20.08.2008 Bulletin 2008/34**

(51) Int Cl.:
   ***H01L 35/34*** (2006.01)   ***H01L 35/14*** (2006.01)

(21) Application number: **06834646.9**

(86) International application number:
   **PCT/JP2006/324891**

(22) Date of filing: **07.12.2006**

(87) International publication number:
   **WO 2007/066820 (14.06.2007 Gazette 2007/24)**

(84) Designated Contracting States:
   **DE FR GB**

(30) Priority: **07.12.2005 JP 2005353251**

(71) Applicant: **TOYOTA JIDOSHA KABUSHIKI KAISHA**
   **Toyota-shi,**
   **Aichi 471-8571 (JP)**

(72) Inventors:
   • **MURAI, Junya,**
   **TOYOTA JIDOSHA KABUSHIKI KAISHA**
   **Toyota-shi, Aichi 4718571 (JP)**

   • **KITA, Takuji,**
   **TOYOTA JIDOSHA KABUSHIKI KAISHA**
   **Toyota-shi, Aichi 4718571 (JP)**

(74) Representative: **Duckworth, Timothy John**
   **J.A. Kemp & Co.,**
   **14 South Square,**
   **Gray's Inn**
   **London WC1R 5JJ (GB)**

(54) **THERMOELECTRIC CONVERSION MATERIAL AND PROCESS FOR PRODUCING THE SAME**

(57)    A thermoelectric conversion material wherein at least a part of the insulating material contained in the thermoelectric conversion material has a particle size not larger than a mean free path of the phonons in the insulating material or wherein a dispersion gap of the insulating material is not larger than a mean free path of the phonons in the thermoelectric conversion material, and a method of producing the thermoelectric conversion material comprising the steps of forming composite nano particles by reducing and precipitating starting particles of a thermoelectric conversion material on the nano particles constituted by an insulating material, followed by a heat treatment to coat the nano particles with the thermoelectric conversion material; and packing and sintering the composite nano particles.

Fig.4

(A)

EP 1 959 508 A1

(B)

(C)

**Description**

Technical Field:

This invention relates to a thermoelectric conversion material and to a method of producing the same. More specifically, this invention relates to a thermoelectric conversion material which contains an insulating material and to a method of producing the same.

Background Art:

The figure of merit ZT of a thermoelectric conversion material that utilizes a Seebeck effect can be expressed by the following formula (1),

$$\text{Formula (1): } ZT = \alpha^2 \sigma T / \kappa$$

where $\alpha$, $\sigma$, $\kappa$ and T are a Seebeck coefficient, an
electric conductivity, a thermal conductivity and a measured temperature, respectively.

To improve performance of the thermoelectric conversion material as will be obvious from the formula (1), it is important to increase the Seebeck coefficient $\alpha$ and the electric conductivity $\sigma$ of the material that is used and to decrease the thermal conductivity $\kappa$.

To decrease the thermal conductivity $\kappa$ of a material, fine particles (inert fine particles) that do not react with the base material of the thermoelectric conversion material are often added to the starting material particles of the thermoelectric conversion material. Namely, inert fine particles work to scatter phonons which serve as the principal factor of heat conduction in a thermoelectric conversion material, and therefore, decrease thermal conductivity $\kappa$.

However, in a conventional thermoelectric conversion materials, inert fine particles are unevenly distributed so that the electric resistivity and other properties are more deteriorated than the effect of scattering the phonons by the inert fine particles, making it difficult to improve performance of the thermoelectric conversion material.

In order to solve the above problem, for example, a thermoelectric conversion material has been proposed by using a starting material in the form of fine particles and by sintering the starting material by homogeneously dispersing therein fine particles that do not react with the base material (see, for example, JP-A-2000-261047).

According to the above prior art, both the starting material and the inert fine particles are in the form of fine particles enabling the inert fine particles to be easily dispersed in the whole base material of the thermoelectric conversion material. Therefore, the inert fine particles are present among the starting material particles at an increased probability preventing the base material particles from being crystallized. Further, the starting material and the inert fine particles are so prepared as to assume the form of particles of which the particle size ratio is nearly 1. Therefore, the inert fine particles are present in the thermoelectric conversion material without being unevenly distributed but being homogeneously distributed therein, suppressing electric resistivity and other properties from being deteriorated by the unevenly distributed inert fine particles.

The above prior art attempts to adjust properties such as electric resistivity and the like that are not directly related to the above formula (1) by homogeneously dispersing inert fine particles, but is studying neither the electric conductivity $\sigma$ nor the thermal conductivity $\kappa$ that are directly related to the figure of merit ZT in the formula (1). Therefore, the inert fine particles according to the above conventional technology have particle sizes of a scale of microns. Besides, the prior art is not closely studying a state where the inert fine particles are dispersed.

The carriers (electrons or positive holes (holes)) contained in the thermoelectric conversion material are capable of conducting both heat and electricity. Therefore, a proportional relationship exists between the electric conductivity $\sigma$ and the thermal conductivity $\kappa$. It has further been known that a reversely proportional relationship exists between the electric conductivity $\sigma$ and the Seebeck coefficient $\alpha$. Generally, therefore, even if the electric conductivity $\sigma$ could be improved, the result is an increase in the thermal conductivity $\kappa$ and a decrease in the Seebeck coefficient $\alpha$. Besides, since the effective mass and the mobility hold a reversely proportional relationship, the effective mass decreases if it is attempted to increase the mobility.

It is therefore, an object of the present invention to provide a thermoelectric conversion material having an excellent figure of merit and a method of producing the thermoelectric conversion material by solving the above problems inherent in the prior art.

Disclosure of the Invention:

In order to solve the above problems according to the present invention, there are provided the following inventions <1> to <8>.

<1> A thermoelectric conversion material of the P-type or N-type in which an insulating material is dispersed, wherein at least part of the insulating material is dispersed maintaining a gap not larger than a mean free path of the phonons in the thermoelectric conversion material.

According to the above invention <1>, the gap of dispersion of at least part of the insulating materials is rendered to be not larger than the mean free path of the phonons in the thermoelectric conversion material, so that the phonons are scattered to a sufficient degree causing a decrease in the thermal conductivity K of the thermoelectric conversion material and that the electric resistivity and like are suppressed from being deteriorated by the uneven distribution of the insulating material enabling the figure of merit ZT to be further improved.

<2> The thermoelectric conversion material of <1> above, wherein at least part of the insulating material has a particle size not larger than the mean free path of the phonons in the thermoelectric conversion material.

<3> The thermoelectric conversion material of <1> or <2> above, wherein at least part of the insulating material is dispersed maintaining a gap not smaller than a mean free path of the carriers in the thermoelectric conversion material but not larger than the mean free path of the phonons in the thermoelectric conversion material.

The carriers (electrons or positive holes (holes)) contained in the thermoelectric conversion material are capable of conducting both heat and electricity. Therefore, a proportional relationship exists between the electric conductivity $\sigma$ and the thermal conductivity $\kappa$. However, when the insulating material is dispersed in the thermoelectric conversion material maintaining a gap not smaller than the mean free path of the carriers in the thermoelectric conversion material, the thermal conductivity $\kappa$ decreases at a rate larger than the rate of decrease of the electric conduction. As a result, the figure of merit ZT increases. Generally, a reversely proportional relationship exists between the electric conductivity $\sigma$ and the Seebeck coefficient $\alpha$. Therefore, as the electric conduction decreases, the Seebeck coefficient $\alpha$ increases.

Namely, on the right side of the formula (1) in this invention, the ratio of decrease of the thermal conductivity $\kappa$ which is the denominator becomes larger than the ratio of decrease of the electric conductivity $\sigma$ which is the numerator while $\alpha$ which is the numerator increases. Therefore, the figure of merit ZT expressed by the formula (1) increases. Besides, it is made possible to suppress the deterioration in the electric resistivity caused by uneven distribution of the insulating material and, therefore, to further increase the figure of merit ZT.

<4> A thermoelectric conversion material of the P-type or N-type in which an insulating material is dispersed, wherein at least part of the insulating material has a particle size not larger than a mean free path of the phonons in the insulating material.

The above invention <4> makes it possible to decrease the thermal conductivity $\kappa$ of the thermoelectric conversion material and, therefore, to increase the figure of merit ZT. The thermal conductivity decreases if the phonons are scattered to a sufficient degree in the thermoelectric conversion material.

Through the step of arriving at the present invention, the inventors have clarified that the phonons are scattered to a sufficient degree when the insulating material dispersed in the thermoelectric conversion material has a particle size not larger than the mean free path of the phonons in the insulating material.

This effect is exhibited when at least part of the insulating material that is contained in the thermoelectric conversion material has a particle size not larger than the mean free path of the phonons.

In the above invention <4>, of the whole insulating material contained in the thermoelectric conversion material, at least part of the insulating material has a particle size not larger than the mean free path of the phonons in the insulating material. When the thermoelectric conversion material contains the insulating material having such a particle size, the thermal conductivity $\kappa$ decreases at a rate larger than the rate of decrease of the electric conductivity $\sigma$. As a result, the figure of merit ZT can be very increased.

<5> The thermoelectric conversion material of <4> above, wherein at least part of the insulating material is dispersed maintaining a gap not larger than the mean free path of the phonons in the thermoelectric conversion material.

<6> The thermoelectric conversion material of <4> or <5> above, wherein at least part of the insulating material is dispersed maintaining a gap not smaller than a mean free path of the carriers in the thermoelectric conversion material but not larger than the mean free path of the phonons in the thermoelectric conversion material.

<7> The thermoelectric conversion material of <1> to <6> above, wherein the insulating material is a rod-like insulating material.

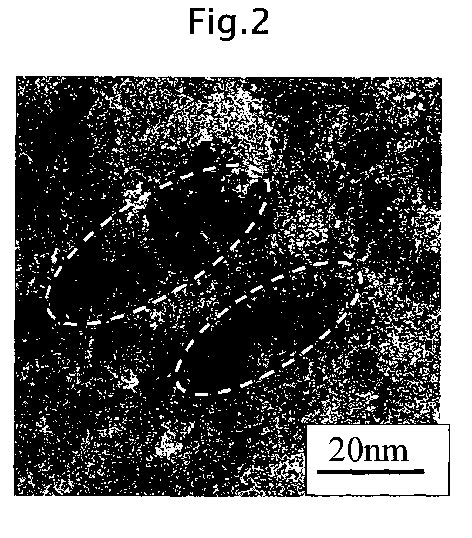

The insulating material dispersed in the thermoelectric conversion material assumes the shape of nearly spherical particles. When the thermoelectric conversion material is formed by the sintering, however, it often happens that the insulating material particles are bonded together to assume the shape of rods as shown in Fig. 2. The rod-like insulating material has a more increased surface area than when it is of a spherical shape, and it is expected that the thermal conductivity can be further decreased.

<8> A method of producing a thermoelectric conversion material comprising the steps of:

forming composite nano particles by reducing and precipitating starting particles of a thermoelectric conversion material on the nano particles constituted by an insulating material, followed by a heat treatment to coat the nano particles with the thermoelectric conversion material; and

packing and sintering the composite nano particles.

According to the invention <8> above, the thermoelectric conversion material can be produced by uniformalizing the gap of dispersion of the insulating material and suppressing a decrease in the electric resistivity caused by uneven distribution of the insulating material.

According to the conventional methods of production, it was attempted to disperse the particles constituted by an insulating material in a base material of the thermoelectric conversion material, or to mix the particles constituted by the thermoelectric conversion material and the particles constituted by the insulating material together followed by sintering. Therefore, it was difficult to reliably suppress the insulating material from being unevenly distributed in the thermoelectric conversion material.

According to the present invention, on the other hand, the surfaces of the particles constituted by an insulating material are coated with a thermoelectric conversion material to form composite nano particles of which the core portions are constituted by the insulating material and the shell portions are constituted by the thermoelectric conversion material. Upon packing and sintering the composite nano particles, the shell portions (coating layers formed of the thermoelectric conversion material) of the neighboring composite nano particles are bonded together. Therefore, the gap of dispersion of the insulating material can be controlled relying upon the thickness of the shell portions, i.e., the insulating material becomes less likely to be bonded together making it possible to reliably suppress the insulating material from being unevenly distributed.

Brief Description of the Drawings:

Fig. 1 is a diagram illustrating the relationship among the texture dimension of a thermoelectric conversion material, Seebeck coefficient $\alpha$, electric conductivity $\sigma$ and thermal conductivity $\kappa$;

Fig. 2 is a TEM photograph of a thermoelectric conversion material of the invention in which the insulating material present in the thermoelectric conversion material is a rod-like insulating material;

Fig. 3 is a diagram schematically illustrating the steps of production in a method of producing the thermoelectric conversion material of the invention;

Fig. 4 is a diagram illustrating the state of the insulating material and the like in the method of producing the thermoelectric conversion material of the invention, wherein Fig. 4(A) illustrates the constitution of a composite nano particle, Fig. 4(B) illustrates a state where the composite nano particles are packed, and Fig. 4(C) illustrates a state after the sintering;

Fig. 5 is a graph illustrating a relationship between the thermal conductivity of a $CoSb_3/Al_2O_3$ thermoelectric conversion material at 400°C and the volume percentage of $Al_2O_3$;

Fig. 6 is a graph illustrating the relationship between the ZT of the $CoSb_3/Al_2O_3$ thermoelectric conversion material at 400°C and the volume percentage of $Al_2O_3$;

Fig. 7 is a graph illustrating the relationship between the thermal conductivity of a thermoelectric conversion material containing $Co_{0.94}Ni_{0.06}Sb_3$ insulating material particles at 400°C and the volume percentage of the insulating material particles;

Fig. 8 is a graph illustrating the relationship between the ZT of the thermoelectric conversion material containing $Co_{0.94}Ni_{0.06}Sb_3$ insulating material particles at 400°C and the volume percentage of the insulating material particles; and

Fig. 9 is a graph illustrating the relationship between the thermal conductivity of a $Bi_2Te_3/SiO_2$ thermoelectric conversion material at 30°C and the volume percentage of $SiO_2$.

Best Mode for Carrying Out the Invention:

The thermoelectric conversion material of the present invention is a thermoelectric conversion material of the P-type or N-type in which an insulating material is dispersed, wherein at least part of the insulating material is dispersed maintaining a gap not larger than a mean free path of the phonons in the thermoelectric conversion material.

It is desired that the insulating material according to the invention is an inorganic insulating material, such as alumina, zirconia, titania, magnesia, silica or composite oxide including thereof, hydrocarbon, aluminum nitride or silicon nitride. Among them, a desired example is silica, zirconia or titania from the standpoint of low thermal conductivity. Further, the insulating material may be used in a single kind or in two or more kinds in combination.

The insulating material has a resistivity which is, preferably, not smaller than 1000 $\mu\Omega m$, more preferably, not smaller than $10^6$ $\mu\Omega m$ and, further preferably, not smaller than $10^{10}$ $\mu\Omega m$. When the resistivity is not larger than 1000 $\mu\Omega m$, the thermal conductivity becomes so high that it becomes difficult to improve ZT.

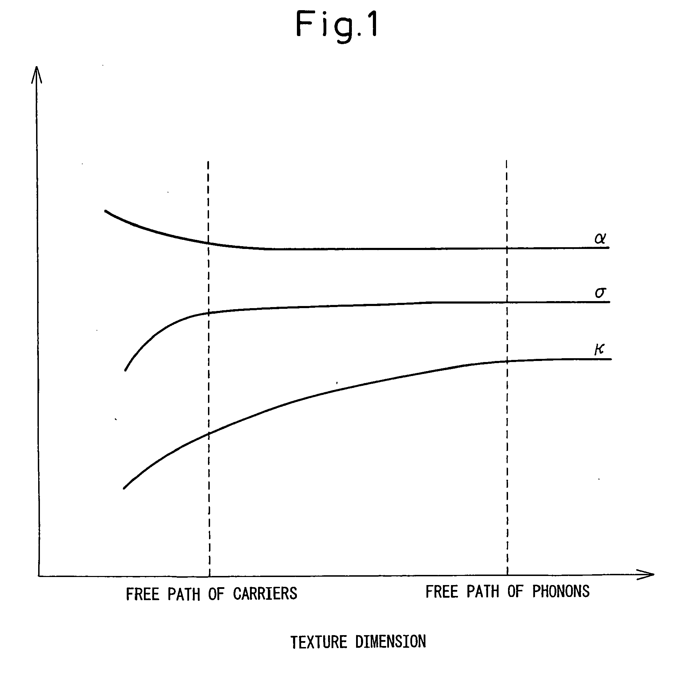

Next, the relationship between the figure of merit ZT and the constitution of texture of the thermoelectric conversion material will be described in detail with reference to Fig. 1.

Referring to Fig. 1, the thermal conductivity K of the thermoelectric conversion material gradually decreases as the texture dimension of the thermoelectric conversion material becomes smaller than the length of a mean free path of the phonons as a starting point. Therefore, the figure of merit ZT increases if the texture dimension is so designed as to become smaller than the mean free path of the phonons.

On the other hand, the electric conductivity $\sigma$ of the thermoelectric conversion material does not decrease even when the texture dimension of the thermoelectric conversion material becomes smaller than the mean free path of the phonons as the starting point but decreases when the texture dimension of the photoelectric conversion material assumes a particle size roughly smaller than the mean free path of the carriers. Thus, by utilizing a difference between the texture dimension of the thermoelectric conversion material at which the thermal conductivity $\kappa$ starts decreasing and the texture dimension of the thermoelectric conversion material at which the electric conductivity $\sigma$ starts decreasing, the texture dimension of the thermoelectric conversion material is so set as to be not smaller than the mean free path of the carriers but not larger than the mean free path of the phonons, so that the rate of decrease in the thermal conductivity $\kappa$ becomes larger than the rate of decrease in the electric conductivity in order to further increase the figure of merit ZT expressed by the above formula (1).

What specifies the texture dimension of the thermoelectric conversion material is a particle size of the insulating material dispersed in the thermoelectric conversion material or a dispersion gap of the insulating material. Therefore, in the invention, the dispersion gap of the insulating material or the particle size of the insulating material is so controlled as to obtain the above effect.

In other words, in the invention, the gap of the insulating material dispersed in the thermoelectric conversion material is not larger than the mean free path of the phonons in the thermoelectric conversion material, and is desirably not smaller than the mean free path of the carriers in the thermoelectric conversion material but is not larger than the mean free path of the phonons in the thermoelectric conversion material.

The mean free paths (MFP) are calculated in compliance with the following formulas.

Carrier MFP = (mobility·effective mass·carrier velocity)/amount of electric charge

Phonon MFP = 3·lattice thermal conductivity/specific heat/speed of sound

In the above formulas, the values are those found in the documents and those approximated from the temperature characteristics. The specific heat is only that which is measured.

Described below are the results of carrier MFP and phonon MFP calculated for $Co_{0.94}Ni_{0.06}Sb_3$ and $CoSb_3$.

Calculated carrier MFP and phonon MFP (mean free paths)

| Material | Temperature | Carrier MFP (nm) | Phonon MFP (nm) |
|---|---|---|---|
| $CO_{0.94}Ni_{0.06}SB_3$ | 300K | 4.8 | 33 |
|  | 673K | 5.1 | 15 |
| $CoSB_3$ | 300K | 0.8 | 85 |
|  | 673K | 1 | 42 |

As described above, the carrier MFP and the phonon MFP are determined depending upon the material and temperature, while $CoSB_3$ exhibits a maximum performance at 400°C (673K). Therefore, decision is based on the mean free path at 400°C.

When the dispersion gap is not larger than the mean free path of the phonons in the thermoelectric conversion material, the phonons are scattered to a sufficient degree and the thermal conductivity $\kappa$ of the thermoelectric conversion material decreases. From the standpoint of lowering the scattering frequency of carriers, further, it is desired that the gap is not smaller than 1 nm. It is further desired that the gap of dispersion is 1 nm to 50 nm since it is not smaller than the mean free path of the carriers of the thermoelectric conversion material, makes it possible to more increase the rate of decrease in the thermal conductivity $\kappa$ than the rate of decrease in the electric conductivity $\sigma$ and, as a result, to increase the figure of merit ZT.

In this invention, the above dispersion gap is possessed by at least part of the insulating material which, desirably, is not smaller than 50%, more preferably, not smaller than 70% and, most preferably, not smaller than 90% by volume of the whole insulating material in the thermoelectric conversion material. When the amount thereof is smaller than 50%, the phonons are not scattered to a sufficient degree and the thermal conductivity $\kappa$ may not be decreased. However, as at least part of the insulating material possesses the above dispersion gap, the thermal conductivity can be more decreased than those of the conventional counterparts.

As described above, further, the particle size of the insulating material dispersed in the thermoelectric conversion material is not larger than the mean free path of the phonons of the insulating material. When the particle size of the insulating material is not larger than the mean free path of the phonons, the phonons are scattered to a sufficient degree due to the presence of the insulating material whereby the thermal conductivity $\kappa$ decreases, and as a result, the figure of merit ZT increases.

In this invention, the above particle size is possessed by at least part of the insulating material which, preferably, is not smaller than 50%, more preferably, not smaller than 70%, and most preferably, not smaller than 95% by volume of the whole insulating material in the thermoelectric conversion material. When the amount thereof is smaller than 50%, the phonons are not scattered to a sufficient degree and the thermal conductivity $\kappa$ may not be decreased. However, as at least part of the insulating material possesses the above particle size, the thermal conductivity can be more decreased than those of the conventional counterparts.

The insulating material dispersed in the thermoelectric conversion material assumes the shape of nearly spherical particles. When the thermoelectric conversion material is to be formed by sintering, particles of the insulating material are often bonded together to form a rod-like insulating material. Further, the rod-like insulating material such as whiskers is often used.

Fig. 2 shows a TEM image of the thermoelectric conversion material using alumina whiskers as the insulating material which is dispersed in $CoSb_3$. The volume percentage of the insulating material was 30%. Further, the sintering was conducted under a pressure of 100 MPa. The insulating material formed in a rod-like shape possesses a surface area greater than that of when the insulating material is formed in a spherical shape, and it is expected that the thermal conductivity can be further decreased.

The thermoelectric conversion material of the present invention may be either of the P-type or the N-type. There is no particular limitation on the P-type thermoelectric conversion material, and there can be used the one of the type of, for example, $Bi_2Te_3$, PbTe, $Zn_4Sb_3$, $CoSb_3$, half-Heusler, full-Heusler, SiGe or the like. There is no particular limitation, either, on the N-type thermoelectric conversion material, and there can be used the one of the type of, for example, $Bi_2Te_3$, PbTe, $Zn_4Sb_3$, $CoSb_3$, half-Heusler, full-Heusler, SiGe, $Mg_2Si$, $Mg_2Sn$, CoSi or the like.

The thermoelectric conversion material of the present invention has an output factor which is, preferably, not smaller than 1 $mW/K^2$, more preferably, not smaller than 2 $mW/K^2$ and, further preferably, not smaller than 3 $mW/K^2$. When the output factor is not larger than 1 $mW/K^2$, greatly improved performance cannot be expected.

The thermoelectric conversion material of the present invention has a thermal conductivity $\kappa$ which is, preferably, not smaller than 2 W/mK, more preferably, not smaller than 3 W/mK and, further preferably, not smaller than 7 W/mK. When the thermal conductivity $\kappa$ is not smaller than 3 W/mK, the effect of the invention is particularly exhibited to a conspicuous degree. In other words, when the texture dimension of the thermoelectric conversion material is controlled in the order of nanometers as specified by the present invention, the thermal conductivity $\kappa$ can be decreased to a large extent as the thermoelectric conversion material that is used has a large thermal conductivity $\kappa$. In particular, the thermal conductivity $\kappa$ can be decreased to a large extent when there is used a thermoelectric conversion material having a thermal conductivity K which is not smaller than 5 W/mK.

It is desired that the ratio of the lattice thermal conductivity to the above thermal conductivity $\kappa$ is, preferably, not smaller than 0.5, more preferably, not smaller than 0.7 and, further preferably, not smaller than 0.9. If the dispersing state of the insulating material is controlled in a scale of nanometers as in the present invention, the phonons scatter vigorously in the interface between the insulating material and the thermoelectric conversion material and, therefore, the lattice thermal conductivity greatly decreases. Therefore, in the material of the invention, when the lattice thermal conductivity occupies a ratio of not less than 0.5 of the thermal conductivity, the thermal conductivity can be greatly decreased and, as a result, the figure of merit ZT can be further improved.

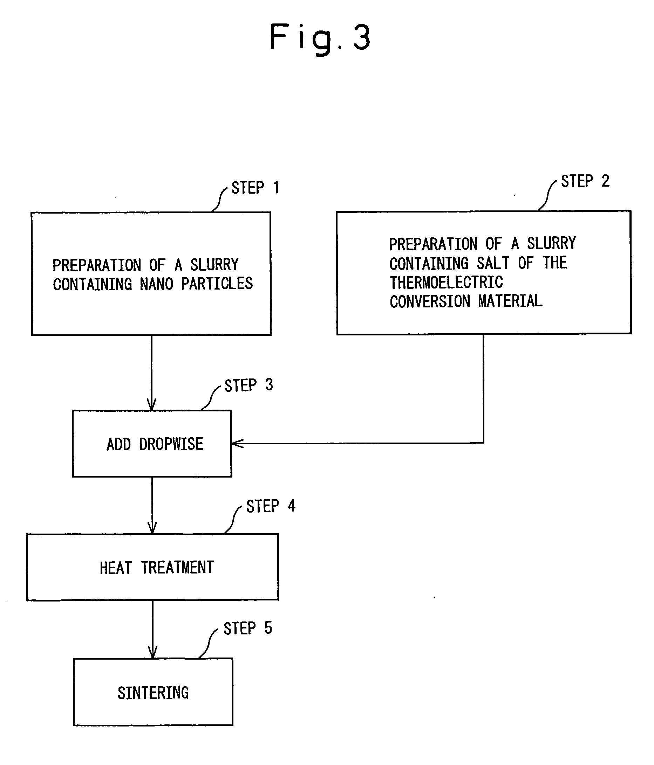

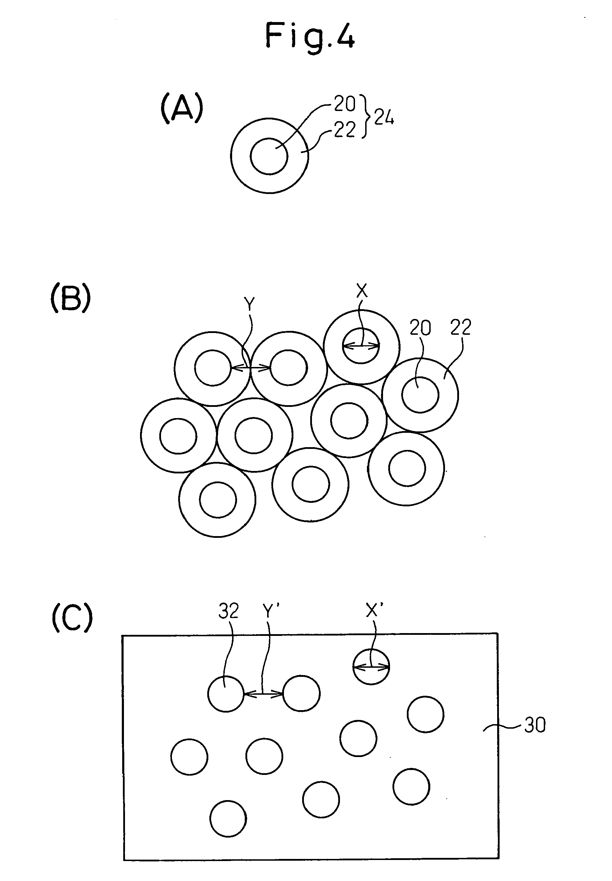

Next, the method of producing the thermoelectric conversion material of the invention will be described in detail with reference to Figs. 3 and 4.

The method of producing the thermoelectric conversion material comprises the steps of forming composite nano particles by reducing and precipitating starting particles of the thermoelectric conversion material on the nano particles constituted by the insulating material, followed by a heat treatment to coat the nano particles with the thermoelectric conversion material; and packing and sintering the composite nano particles.

There is no particular limitation on the step of forming composite nano particles by reducing and precipitating starting particles of the thermoelectric conversion material on the nano particles constituted by the insulating material, followed by the heat treatment to coat the nano particles with the thermoelectric conversion material. The above-mentioned materials can be used as the thermoelectric conversion material and the insulating material. The step of forming composite nano particles will be described in further detail.

First, a slurry of nano particles constituted by the insulating material is prepared (step 1 in Fig. 3). Here, it is desired that the insulating material has a particle size not larger than a mean free path of the phonons. Upon using the insulating material having such a particle size, the particle size of the insulating material dispersed in the thermoelectric conversion material that is formed becomes smaller than the mean free path of the phonons of the insulating material, the phonons scatter to a sufficient degree in the thermoelectric conversion material, the thermal conductivity $\kappa$ of the thermoelectric conversion material decreases, and the figure of merit ZT thereof increases.

The slurry is prepared by adding nano particles constituted by the insulating material, a pH-adjusting agent and a reducing agent to a solvent. There is no particular limitation on the solvent provided it is capable of dispersing the nano particles. Its examples include alcohol, water and the like, and it is desirable to use ethanol. The pH-adjusting agent is used for suppressing the coagulation of nano particles in the slurry, and any known one can be suitably used, such as nitric acid, ammonia water or sodium boron hydride ($NaBH_4$). The reducing agent may be the one capable of reducing ions that constitute starting base of the thermoelectric conversion material and may be, for example, NaBH, hydrazine or the like. It is desirable that the slurry has a pH that is adjusted at preferably, 8 to 11, and more preferably, 9 to 11.

Next, another slurry is prepared by dispersing a starting salt of the thermoelectric material in a solvent (step 2 in Fig. 3). When the thermoelectric conversion material is $CoSb_3$, the starting salt of the thermoelectric conversion material is a hydrate of cobalt chloride or antimony chloride. There is no particular limitation on the amount of the starting salt in the slurry provided the amount of the starting salt is such that the starting salt is allowed to be dispersed in the solvent. It is therefore, desired that the amount of the starting salt is suitably adjusted depending upon the kind of the solvent and the kind of the starting salt. There is no particular limitation on the solvent provided it is capable of dispersing the starting salt of the thermoelectric conversion material. The examples will include alcohol, water and the like, and it is desirable to use ethanol.

Next, the slurry containing the starting salt of the thermoelectric conversion material obtained at step 2 is added dropwise to the slurry containing nano particles constituted by the insulating material obtained at step 1 (step 3 in Fig. 3). Starting ions of the thermoelectric conversion material, such as Co ions and Sb ions are present in the slurry that contains the starting salt of the thermoelectric conversion material. Upon being mixed with the slurry of nano particles constituted by the insulating material and including the reducing agent, therefore, the ions are reduced, and the starting particles of the thermoelectric conversion material, such as Co particles and Sb particles, are precipitated on the surfaces of the nano particles constituted by the insulating material. Through the reduction, there are formed Co particles and Sb particles, as well as such by-products as NaCl and $NaBO_3$. It is desirable that the by-products are removed by filtration. After the filtration, it is desired to wash the by-products away by adding alcohol or water thereto.

The slurry obtained at step 3 is heat-treated by using, for example, an autoclave or the like (step 4 in Fig. 3). Through the heat treatment, the thermoelectric conversion material is hydrothermally synthesized from the starting particles of the thermoelectric conversion material. The time and temperature of the heat treatment differ depending upon the kinds and contents of the solvent that is used and of the thermoelectric conversion material, and are therefore, better suitably adjusted. Composite nano particles 24 constituted by a core portion 20 of the insulating material and a shell portion 22 of the thermoelectric conversion material as shown in Fig. 4(A) are hydrothermally synthesized by the heat treatment.

The mean thickness of the coating layer of the thermoelectric conversion material of the obtained composite nano particles is, desirably, not larger than the mean free path of the phonons of the thermoelectric conversion material, more preferably, not larger than one-half the mean free path of the phonons of the thermoelectric conversion material, and further preferably, not smaller than one-half the mean free path of the carriers of the thermoelectric conversion material but is not larger than one-half the mean free path of the phonons of the thermoelectric conversion material.

In the next step of sintering, the composite nano particles are packed and sintered. The total thickness of the coating layers of neighboring composite nano particles that are packed becomes nearly equal to the dispersion gap of the insulating material. Therefore, if the mean thickness of the coating layers of the composite nano particles is selected to be one-half the mean free path of the phonons of the thermoelectric conversion material, the dispersion gap of the insulating material in the thermoelectric conversion material becomes nearly equal to the mean free path of the phonons.

The thickness of the coating layer can be controlled by adjusting the ratio of the number of particles of the insulating material added to the slurry and the amount of the thermoelectric conversion material in the slurry. As described above, the present invention makes it possible to control the thickness of the coating layer constituted by the thermoelectric conversion material of the composite nano particles, and therefore, to control the dispersion gap of the insulating material in the thermoelectric conversion material that is finally obtained.

In the subsequent step of sintering, the obtained composite nano particles 24 are packed and sintered (step 5 in Fig. 3). Fig. 4(B) illustrates a state where the composite nano particles are packed. If sintered in this state, the shell portions (coating layers formed of the thermoelectric conversion material) of the neighboring composite nano particles are bonded together to form a network (Fig. 4(C)). The particle size X of the core portion 20 (insulating material) of the composite nano particles when packed as shown in Fig. 4(B) becomes nearly the same as the particle size X' of the insulating material after sintered shown in Fig. 4(C). Further, though subject to vary depending upon the packing density of the composite nano particles, the distance Y of the total thicknesses of the shell portions 22 of the neighboring composite nano particles when packed as shown in Fig. 4(B) stems from the dispersion distance Y' of the insulating material after sintered shown in Fig. 4(C).

In the production method of the present invention as shown in Fig. 4(B), the thermoelectric conversion material is interposed as shell portions 22 between the insulating materials preventing the insulating materials from being bonded together, and therefore, more reliably suppressing the insulating materials from being unevenly distributed than in the conventional method. Further, since the dispersion gap of the insulating material can be controlled depending upon the thickness of the shell portions 22, it is allowed to design a thermoelectric conversion material in which the phonons are scattered to a sufficient degree to enhance the figure of merit ZT.

In addition to the sintering step, there may be added a step of forming the thermoelectric conversion material by applying a pressure. When the rod-like insulating material is present, application of pressure in a predetermined direction causes the direction of long diameter of the rod-like insulating material to be oriented in a predetermined direction, i.e., the direction of long diameter becomes nearly perpendicular to the direction in which pressure is applied. It is, therefore, desirable to so apply the pressure that the pressurizing direction is nearly perpendicular to the direction in which electricity is conducted through the thermoelectric conversion material.

In the present invention, the step of sintering and the step of forming may be separately provided to separately carry out the forming by applying the pressure and the sintering. However, it is, desirable to conduct the sintering while executing the forming by applying the pressure. As the method of sintering while executing the forming by applying the pressure, there can be used any one of the hot-press sintering method, hot equipressurized sintering method or electric discharge plasma sintering method. Among them, the electric discharge plasma sintering method is preferred from the standpoint of conducting the sintering by elevating the pressure in a short period of time and easily controlling the growth of particles.

The sintering temperature in the discharge plasma sintering method is, preferably, 600 to 900°C and, more preferably, 650 to 850°C. The sintering time is, preferably, not longer than 90 minutes and, more preferably, not longer than 60 minutes. The pressure that is applied is, preferably, not smaller than 20 MPa, and more preferably, not smaller than 40 MPa.

The method of producing the thermoelectric conversion material of the present invention may further suitably include an additional step in addition to the above steps. The additional step may be, for example, a step of classifying the composite nano particles.

As described above, the method of producing the thermoelectric conversion material of the invention makes it possible to control the texture dimensions (particle size of the insulating material and the dispersion gap of the insulating material) in the order of nanometers.

In addition to being produced by the above production method, the thermoelectric conversion material of the invention may be produced by preparing insulating material particles and thermoelectric conversion material particles, and mixing them together followed by sintering. In either way, if the texture dimensions (particle size of the insulating material and dispersion gap of the insulating material) of the thermoelectric conversion material are not larger than the mean free path of the phonons or, preferably, are not smaller than the mean free path of the carriers but are not larger than the mean free path of the phonons, then the phonons are scattered to a sufficient degree in the thermoelectric conversion material and the thermal conductivity $\kappa$ can be decreased. As a result, the thermoelectric conversion material is obtained having a large figure of merit $\kappa$ as expressed by the formula (1).

As described above, the thermoelectric conversion material of the invention is an excellent thermoelectric conversion material exhibiting a high figure of merit ZT. Namely, there is obtained the thermoelectric conversion material having a figure of merit ZT of not smaller than 2 that could not be produced so far.

EXAMPLES

A slurry (1) was prepared by dispersing 3.6 g of $NaBH_4$ and 12 g of alumina (mean particle size of 15 to 25 nm) in 100 mL of ethanol. Further, a slurry (2) was prepared by adding 1.00 g of $CoCl_2 \cdot 6H_2O$ and 2.88 g of $SbCl_3$ to 100 mL of ethanol and further adding thereto the nitric acid as a pH-adjusting agent to adjust the pH thereof to be 6.0.

The above slurry (1) was added dropwise to the slurry (2), and the mixture was held at 25°C for 0.5 hours, so that nano particles of Co and Sb were precipitated on the alumina particles. The slurry was filtered and the filtrate was introduced into a mixed solution of ethanol, and water, which was thereafter, stirred and filtered. This operation was repeated twice. After filtered two times, ethanol was added thereto to prepare 100 mL of slurry.

The obtained slurry was heat-treated in an autoclave container at 240°C for 24 hours to obtain composite nano particles.

By using an electric discharge plasma sintering apparatus (SPS), the composite nano particles were sintered under a pressure of 40 MPa, at a temperature of 600°C for 30 minutes to obtain a P-type thermoelectric conversion material that was a nano composite sintered body. The pressure at the time of sintering was applied perpendicularly to the direction in which electricity is conducted through the thermoelectric conversion material.

Observation of the formed composite nano particles by using a TEM showed that the core portions (alumina) possessed a mean particle size of 20 nm and the shell portions (coating layer) possessed a mean thick of 20 nm. The mean particle size of the core portions (alumina) and the mean thickness of the shell portions (coating layer) were calculated by observing 20 composite nano particles by using the TEM.

The obtained thermoelectric conversion material (1) was measured for its electric conductivity $\sigma$, Seebeck coefficient and thermal conductivity K to calculate a figure of merit ZT. The thermoelectric conversion material (1) possessed an electric conductivity $\sigma$ of $47.6 \times 10^3\ \Omega^{-1}m^{-1}$, a Seebeck coefficient of 205 $\mu$V/K, a thermal conductivity $\kappa$ of 0.9 W/mK, and a figure of merit ZT of 1.5.

The electric conductivity $\sigma$ was measured by the four-terminal method. The Seebeck coefficient was found by pushing a thermoelectric couple wire onto a sample obtained by cutting a portion of the thermoelectric conversion material (1), imparting a temperature differential to the sample in a heating-up furnace, and measuring the thermoelectromotive force. The thermal conductivity $\kappa$ was calculated by multiplying together the density measured by the volumetric method, the specific heat measured by the DSC method and the thermal diffusion factor measured by the laser flash method by using a Xe lamp. The figure of merit (ZT) was calculated in compliance with the above formula (1).

Observation of the obtained thermoelectric conversion material (1) by using the TEM, further, showed that the dispersion gap of the insulating material was about 20 nm. Further, not less than 80%, calculated as volume, of the insulating material dispersed in the thermoelectric conversion material (1) possessed a particle size of not larger than the mean free path of the phonons.

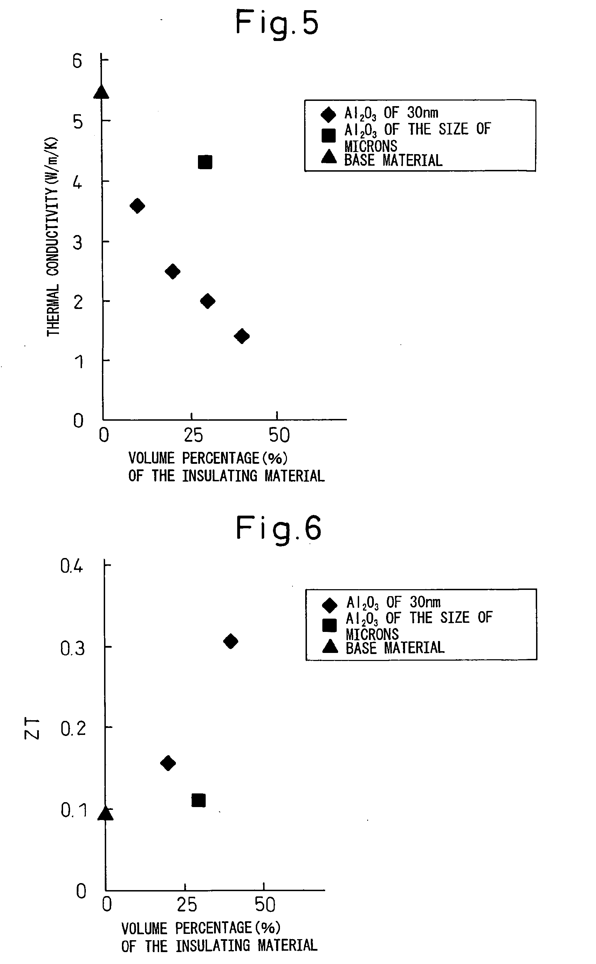

Further, a thermoelectric conversion material comprising $Al_2O_3$ and $CoSb_3$ of 30 nm was prepared in the same manner as above, and was measured for its relationship among the volume percentage of $Al_2O_3$, thermal conductivity at 400°C and ZT to obtain the results as shown in Figs. 5 and 6. Also shown as a reference are the results of when $Al_2O_3$ of a size of microns (particle size of 4 $\mu$m) was used.

From the standpoint of decreasing the thermal conductivity, it is desired to increase the volume percentage of the insulating material which, however, may cause a decrease in the electric conductivity. It can, therefore, be said that an optimum ratio is determined by a combination of the materials. As the size of the insulating material decreases, further, the surface area thereof increases making it possible to further decrease the thermal conductivity. When the insulating material has a small size, therefore, the effect is obtained for decreasing the thermal conductivity with a small amount of use, making it possible to maintain the electric conductivity.

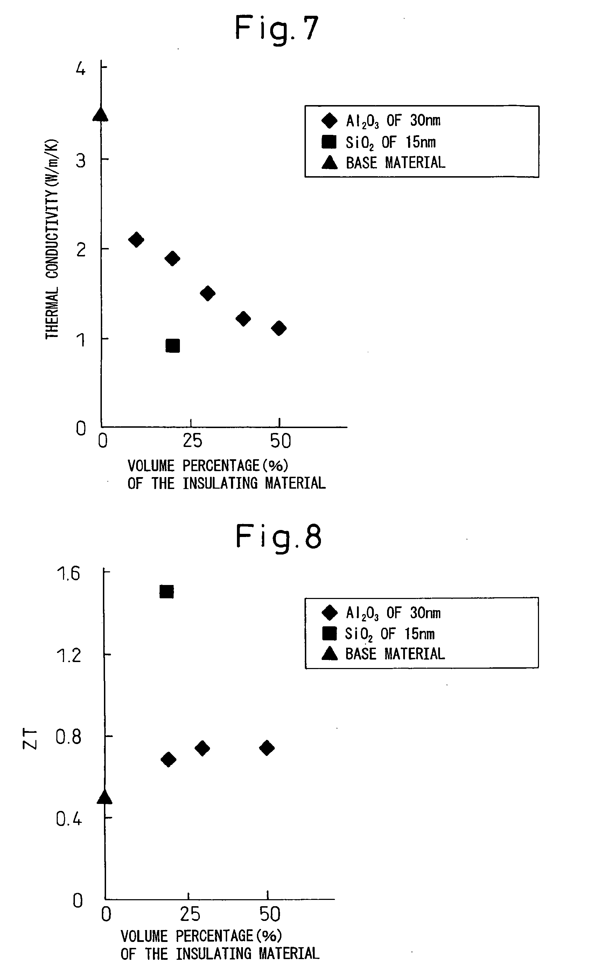

Next, a thermoelectric conversion material comprising $Al_2O_3$ and $Co_{0.94}Ni_{0.06}Sb_3$ of 30 nm and a thermoelectric conversion material comprising $SiO_2$ and $Co_{0.94}Ni_{0.06}Sb_3$ of 15 nm were prepared, and were measured for their relationships among the volume percentage the insulating material, thermal conductivity at 400°C and ZT to obtain the results as tabulated below and as shown in Figs. 7 and 8.

$$Co_{0.94}Ni_{0.06}Sb_3/Al_2O_3$$

1 - Vol. percentage of $Al_2O_3$
2 - Base material
3 - Seebeck coefficient ($\mu$V/K)
4 - Resistivity ($\mu\Omega$m)
5 - Thermal conductivity (W/m/K)

$$Co_{0.94}Ni_{0.06}Sb_3/SiO_2$$

1 - Vol. percentage of $SiO_2$
2 - Base material
3 - Seebeck coefficient ($\mu$V/K)
4 - Resistivity ($\mu\Omega$m)
5 - Thermal conductivity (W/m/K)

The $Co_{0.94}Ni_{0.06}Sb_3$ can be prepared by also adding $NiCl_2 \cdot 6H_2O$ dropwise at step 3 where the thermoelectric material is added dropwise to the slurry of the insulating material. The ratio is so adjusted as to obtain a desired composition.

A thermoelectric conversion material obtained by adding 50 vol% of alumina to the $Co_{0.94}Ni_{0.06}Sb_3$ was observed through the TEM to find that 80% of the alumina possessed a size of not larger than the mean free path (= 15 nm) of the phonons. Further, a thermoelectric conversion material obtained by adding 10 vol% of alumina to the $Co_{0.94}Ni_{0.06}Sb_3$

was observed through the TEM to find that 10% of the alumina possessed a size of not larger than the mean free path (= 15 nm) of the phonons. Since the amount of the insulating material was small, an increased proportion thereof possessed a distance larger than the mean free path. However, as tabulated above, the thermal conductivities were smaller than those of the base material and those using $Al_2O_3$ of 4 $\mu$m.

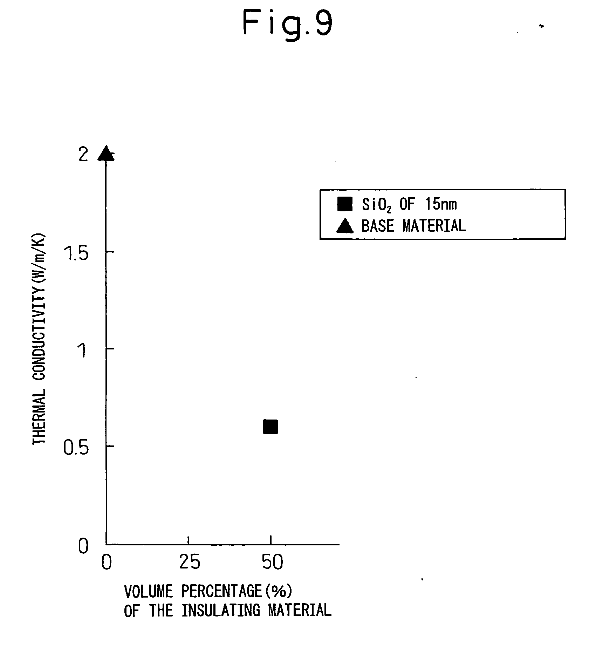

Further, a thermoelectric conversion material was similarly prepared by using $Bi_2Te_3$ as the thermoelectric conversion material and compounded with $SiO_2$ of 15 nm, and was measured for its thermal conductivity. The results were as shown in Fig. 9. The thermal conductivity greatly decreased due to the compounding.

**Claims**

1. A thermoelectric conversion material of the P-type or N-type in which an insulating material is dispersed, wherein at least part of the insulating material is dispersed maintaining a gap not larger than a mean free path of the phonons in the thermoelectric conversion material.

2. The thermoelectric conversion material according to claim 1, wherein at least part of the insulating material has a particle size not larger than the mean free path of the phonons in the thermoelectric conversion material.

3. The thermoelectric conversion material according to claim 1 or 2, wherein at least part of the insulating material is dispersed maintaining a gap not smaller than a mean free path of the carriers in the thermoelectric conversion material, but not larger than the mean free path of the phonons in the thermoelectric conversion material.

4. A thermoelectric conversion material of the P-type or N-type in which an insulating material is dispersed, wherein at least part of the insulating material has a particle size not larger than a mean free path of the phonons in the insulating material.

5. The thermoelectric conversion material according to claim 4, wherein at least part of the insulating material is dispersed maintaining a gap not larger than the mean free path of the phonons in the thermoelectric conversion material.

6. The thermoelectric conversion material according to claim 4 or 5, wherein at least part of the insulating material is dispersed maintaining a gap not smaller than a mean free path of the carriers in the thermoelectric conversion material but not larger than the mean free path of the phonons in the thermoelectric conversion material.

7. The thermoelectric conversion material according to any one of claims 1 to 6, wherein the insulating material is a rod-like insulating material.

8. A method of producing a thermoelectric conversion material comprising the steps of:

   forming composite nano particles by reducing and precipitating starting particles of a thermoelectric conversion material on the nano particles constituted by an insulating material, followed by a heat treatment to coat the nano particles with the thermoelectric conversion material; and
   packing and sintering the composite nano particles.

# Fig.1

FREE PATH OF CARRIERS  FREE PATH OF PHONONS

TEXTURE DIMENSION

# Fig.2

20nm

# Fig.3

PREPARATION OF A SLURRY
CONTAINING NANO PARTICLES
— STEP 1

PREPARATION OF A SLURRY
CONTAINING SALT OF THE
THERMOELECTRIC
CONVERSION MATERIAL
— STEP 2

ADD DROPWISE
— STEP 3

HEAT TREATMENT
— STEP 4

SINTERING
— STEP 5

# Fig.4

(A)

(B)

(C)

# Fig.5

THERMAL CONDUCTIVITY (W/m/K)

◆ Al₂O₃ OF 30nm
■ Al₂O₃ OF THE SIZE OF MICRONS
▲ BASE MATERIAL

VOLUME PERCENTAGE(%)
OF THE INSULATING MATERIAL

# Fig.6

ZT

◆ Al₂O₃ OF 30nm
■ Al₂O₃ OF THE SIZE OF MICRONS
▲ BASE MATERIAL

VOLUME PERCENTAGE(%)
OF THE INSULATING MATERIAL

# Fig. 7

# Fig. 8

# Fig.9

<div align="center">

**INTERNATIONAL SEARCH REPORT**

</div>

| | International application No. |
|---|---|
| | PCT/JP2006/324891 |

| A. CLASSIFICATION OF SUBJECT MATTER |
|---|
| $H01L35/34$(2006.01)i, $H01L35/14$(2006.01)i |
| |
| According to International Patent Classification (IPC) or to both national classification and IPC |

| B. FIELDS SEARCHED |
|---|
| Minimum documentation searched (classification system followed by classification symbols) |
| H01L35/34, H01L35/14 |
| |
| Documentation searched other than minimum documentation to the extent that such documents are included in the fields searched |
| Jitsuyo Shinan Koho  1922-1996  Jitsuyo Shinan Toroku Koho  1996-2007 |
| Kokai Jitsuyo Shinan Koho  1971-2007  Toroku Jitsuyo Shinan Koho  1994-2007 |
| |
| Electronic data base consulted during the international search (name of data base and, where practicable, search terms used) |
| |

| C. DOCUMENTS CONSIDERED TO BE RELEVANT | | |
|---|---|---|
| Category* | Citation of document, with indication, where appropriate, of the relevant passages | Relevant to claim No. |
| X | JP 11-317548 A  (Director General, Agency of Industrial Science and Technology), 16 November, 1999 (16.11.99), Par. Nos. [0007], [0014], [0017] (Family: none) | 1-7 |
| X | JP 2003-225743 A  (Ishikawajima-Harima Heavy Industries Co., Ltd.), 12 August, 2003 (12.08.03), Claim 8; Par. No. [0005] (Family: none) | 1-7 |
| X | JP 9-074229 A  (Matsushita Electric Works, Ltd.), 18 March, 1997 (18.03.97), Claim 1; Par. No. [0004] (Family: none) | 1-7 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 06 March, 2007 (06.03.07) | 20 March, 2007 (20.03.07) |
| Name and mailing address of the ISA/ | Authorized officer |
| Japanese Patent Office | |
| Facsimile No. | Telephone No. |

Form PCT/ISA/210 (second sheet) (April 2005)

## INTERNATIONAL SEARCH REPORT

| | International application No. |
|---|---|
| | PCT/JP2006/324891 |

C (Continuation). DOCUMENTS CONSIDERED TO BE RELEVANT

| Category* | Citation of document, with indication, where appropriate, of the relevant passages | Relevant to claim No. |
|---|---|---|
| X | JP 11-097750 A (Toshiba Corp.), 09 April, 1999 (09.04.99), Par. No. [0038] (Family: none) | 1-7 |
| X | JP 6-302866 A (Idemitsu Materials Co., Ltd.), 28 October, 1994 (28.10.94), Claim 1 (Family: none) | 1-7 |
| X | JP 2005-294478 A (Dainippon Printing Co., Ltd.), 20 October, 2005 (20.10.05), Par. Nos. [0008], [0018], [0036] to [0037], [0040], [0071], [0073] & US 2005/068956 A1 | 1-8 |

Form PCT/ISA/210 (continuation of second sheet) (April 2005)

**INTERNATIONAL SEARCH REPORT**

International application No.

PCT/JP2006/324891

| Box No. II | Observations where certain claims were found unsearchable (Continuation of item 2 of first sheet) |
|---|---|

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

| Box No. III | Observations where unity of invention is lacking (Continuation of item 3 of first sheet) |
|---|---|

This International Searching Authority found multiple inventions in this international application, as follows:
See extra sheet

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest** the
☐ The additional search fees were accompanied by the applicant's protest and, where applicable, payment of a protest fee..

☐ The additional search fees were accompanied by the applicant's protest but the applicable protest fee was not paid within the time limit specified in the invitation.

☒ No protest accompanied the payment of additional search fees.

Form PCT/ISA/210 (continuation of first sheet (2)) (April 2005)

| **INTERNATIONAL SEARCH REPORT** | International application No. |
|---|---|
| | PCT/JP2006/324891 |

Continuation of Box No.III of continuation of first sheet(2)

As specified in Rule 13.2 of the Patent Cooperation Treaty, the requirement of unity of invention in the international application (Rule 13.1 of the Patent Cooperation Treaty) is satisfied only when there is a technical relationship among a group of inventions described in the claims involving one or more of the same or corresponding special technical features (a technical feature that defines a contribution which each of the inventions, considered as a whole, makes over the prior art).

At the outset, the unity of invention among claim 1, claim 4 and claim 8 as independent claims will be reviewed.
The invention of claim 1 relates to "a thermoelectric conversion material in which at least a part of an insulating material is dispersed in at spacings of not more than the mean free path of phonon of the thermoelectric conversion material".
The invention of claim 4 relates to "a thermoelectric conversion material in which at least a part of an insulating material has a particle diameter of not more than the mean free path of phonon of the insulating material".
The invention of claim 8 relates to "a process for producing a thermoelectric conversion material, comprising reductively precipitating raw material particles of a thermoelectric conversion material on nanoparticles formed of an insulating material, heat treating the assembly". There is no technical relationship among claim 1, claim 4 and claim 8 involving one or more of the same or corresponding special technical features (a technical feature that defines a contribution which each of the inventions, considered as a whole, makes over the prior art).
Accordingly, claim 1, claim 4 and claim 8 do not satisfy the requirement of unity of invention.

Next, the unity of invention among claim 1, claim 2 dependent upon claim 1 and claim 3 will be reviewed.
In this case, a technical feature common to the invention of claim 1, the invention of claim 2 and the invention of claim 3 is matter described in claim 1.
On the other hand, the invention of claim 1 is described in JP 11-317548 A (Secretary of AIST) 16 November, 1999 (16.11.99), [0007], [0014] and [0017].
Accordingly, the above common technical matter has already been a known technical feature at the time of filing of this international application and thus cannot be said to be a technique which makes contribution over the prior art and is not a special technical feature specified in the above rule.
Further, any other same or corresponding special technical feature does not exist among the above inventions.
Thus, claim 1, claim 2 and claim 3 also do not satisfy the requirement of unity of invention.

For the reasons set out above, in this application, the same or corresponding special technical feature does not exist among the above inventions, and, thus, the inventions of the claims in this international application do not satisfy the requirement of unity of invention specified in Rule 13.1 based on the Patent Cooperation Treaty.

Form PCT/ISA/210 (extra sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000261047 A